# EUROPÄISCHE PATENTSCHRIFT

(11) **EP 0 445 897 B1**
(45) Veröffentlichungstag und Bekanntmachung des Hinweises auf die Patenterteilung: **21.09.1994**
(21) Anmeldenummer: 91250037.8
(22) Anmeldetag: 08.02.1991
(51) Int. Cl.: C23C 14/28

(54) **Verfahren zur Abscheidung dünner und dünnster Schichten**
Process for deposition of thin and very thin layers
Procédé de déposition des couches minces et ultra-minces

(30) Priorität: 27.02.1990 DD 338176
(43) Veröffentlichungstag der Anmeldung: 11.09.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: Mai, Hermann, Dr. rer. nat., O-8010 Dresden (DE); Gantz, Thomas, O-8010 Dresden (DE)

(56) Entgegenhaltungen:
- EP-A- 0 302 684
- PATENT ABSTRACTS OF JAPAN, Band 8, Nr. 236 (C-249)[1673], 30. Oktober 1984; & JP-A-59 116 373
- REV. SCI. INSTRUM., Band 60, Nr. 8, August 1989, Seiten 2657-2665, American Institute of Physics, New York, US; T. MOTOHIRO et al.: "Angular-resolved ion-beam sputtering apparatus for large-area deposition"

## Beschreibung

Die Erfindung bezieht sich auf das Gebiet der Optik, insbesondere Röntgenoptik, und der Mikroelektronik. Sie findet Anwendung in LPVD-Anlagen zur Herstellung dünner und dünnster Schichten.

Es ist bekannt, dünne Schichten auf einem Substrat in einer LPVD-Anlage abzuscheiden (A.D. Achsaljan, S.W. Gaponow, S.A. Gusew et al. Journ. Techn. Fiz. (russ.), 54(1984), 755; oder JP-A-59 116 373 (Kogyo Gijutsuin) in Patent Abstracts of Japan, Bd. 8, Nr. 236 (C-249) [1673], 30.10.1984). Dabei sind das Substrat sowie das Target, welches eine (ebene) plane oder gekrümmte Oberfläche aufweist, in einem HV- oder einem UHV-Rezipienten angeordnet. Ort und Richtung der Bezugsachsen bzw. Oberflächen-Normalen der Grundeinheiten bestimmen wesentlich das Ergebnis des Schichtabscheidungsprozesses. Der unter einem Winkel Θ gegen die Normale des bestimmten Target-Oberflächenelementes (≙zu verdampfender Zone) einfallende Laserstrahl wird von einer im Strahlengang befindlichen Linse so fokussiert, daß der Brennfleck am Ort der zu verdampfenden Zone entsteht. Von diesem Ort wird dann bei Photonenbeschuß eine Plasmawolke in den Raumwinkel ΔΩ emittiert, dessen Mittelachse A parallel zur Normalen des betreffenden Target-Oberflächenelementes liegt. Die Plasmateilchen fliegen auf das dem Target gegenüberstehende Substrat, dessen Oberflächennormale gleichfalls parallel zu A liegt. An der Substratoberfläche kondensieren die ankommenden Plasmateilchen und bilden die gewünschte dünne Schicht.

Ein Mangel dieses Verfahrens besteht darin, daß es eine ortsabhängige Abscheiderate und damit eine Ortsabhängigkeit der Dicke der abgeschiedenen Schicht auf der Substratoberfläche zur Folge hat. Die Ursache des Mangels besteht darin, daß sich bei der Emissions-Richtcharakteristik der Plasmawolke der integrale Teilchenfluß für definierte Entfernungen vom emittierenden Target-Oberflächenelement mit dem Abstand senkrecht zur Mittelachse A ändert.

Das Ziel der Erfindung besteht darin, ein Verfahren zur Abscheidung dünner und dünnster Schichten mittels LPVD anzugeben, das keine ortsabhängige Abscheiderate und damit keine Ortsabhängigkeit der Dicke der abgeschiedenen Schicht auf der Substratoberfläche zur Folge hat.

Der Erfindung liegt die Aufgabe zugrunde, ein Verfahren zur Abscheidung dünner und dünnster Schichten mittels LPVD vorzuschlagen, bei dem sich der integrale Teilchenfluß für definierte Entfernungen vom emittierenden Target-Oberflächelement nicht mit dem Abstand senkrecht zur Mittelachse A ändert. Erfindungsgemäß wird die Aufgabe mit einem Verfahren, bei dem die Targetoberfläche gekrümmt ist und eine Relativbewegung von Laserstrahlfokus und Targetoberfläche erfolgt, dadurch gelöst, daß eine Verkippung der Symmetrieachse der Plasmafackel (Strahlachse) und der Substratnormalen gegeneinander durch entsprechende Target- und/oder Substratbewegung und die Targetbewegung durch X-Y-Verschiebung mittels Manipulator von außerhalb des Rezipienten und eine damit gekoppelte erzwungene Bewegung in Z-Richtung z.B. durch Schablone erfolgen. Dadurch wird die infolge X-Bewegung hervorgerufene Abweichung der Targetoberfläche aus dem Laserstrahlfokus kompensiert. Ein wesentlicher Vorteil dieses Verfahrens besteht darin, daß hier keine Ortsabhängigkeit von Abscheiderate und Schichtdicke besteht und somit eine gleichmäßige Beschichtung auch großflächiger Substrate ermöglich wird. Weitere Vorteile bestehen in der vereinfachten Bewegungsmöglichkeit von Target und Substrat gegeneinander und der günstigen Aufbaumöglichkeit für UHF-Systeme, da keine Übertragung von kombinierten Kipp- und Drehbewegungen von außerhalb ins Vakuum und keine Anordnung von Spulen usw. im UHV notwendig sind.

### Ausführungsbeispiel

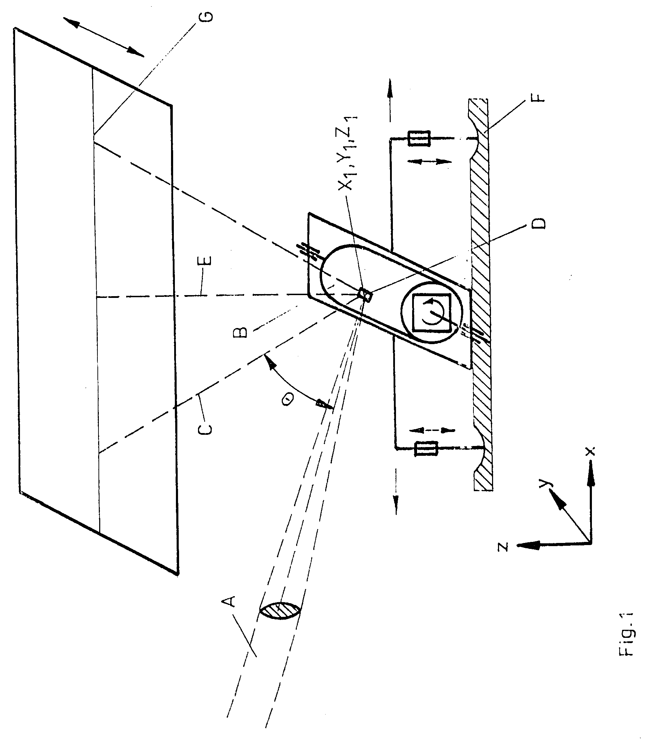

Der schematische Aufbau der verbesserten LPVD-Anordnung ist in Fig. 1 dargestellt. Beim Beschichtungsprozeß trifft der Laserstrahl A unter dem Winkel Θ auf die gekrümmte Targetoberfläche B (Zylindergeometrie, d.h. Krümmung in X-Z-Ebene). Während der Beschichtung wird der Winkel Θ (Neigung von Laserstrahl A gegen die Normale C des jeweils emittierenden Target-Oberflächenelementes) konstant gehalten. Der Laserstrahlfokus D wird gleichfalls ortsfest im Punkte X₁, Y₁, Z₁ während der Beschichtung gehalten. Zur Richtungsänderung von C gegenüber der Substratnormalen E wird das Target geradlinig in X-Richtung verschoben. Die Krümmung der Oberfläche bedingt eine entsprechende Richtungsänderung von C in der X-Z-Ebene und damit eine Änderung der Neigung gegen die Substratnormale bzw. eine Änderung des Auffreffortes der Plasmawolke auf dem Substrat. Zur Verhinderung einer Abweichung des Laserstrahlfokus D aus der Targetoberfläche erzwingt gleichzeitig eine Schablonenführung F die Ortskorrektur der beschossenen Targetoberflächenzone in Z-Richtung. Damit wird es möglich, bei konstant gehaltenen Verdampungsbedingungen den Schnittpunkt von C mit der Substratoberfläche längs der Substratlängsachse G zu führen und eine gleichmäßige Schichtabscheidung in dieser Richtung zu erzielen. Zur Erreichung eines gleichmäßigen Materialabtrages an der Targetoberfläche und zur Vermeidung von Kraterwall-Ausbildung wird das Target in Y-Richtung verschoben, so daß sich im Gesamtprozeß eine zeilenförmige Abrasterung der Targetoberfläche ergibt. Zur Erzielung einer gleichmäßigen Schichtabscheidung in Substratquerrichtung wird entweder
a) das Substrat um die Z-Richtung in Rotation versetzt und die Bahngeschwindigkeit des gerade zu beschichtenden Flächenelements mit der Pulsrate des Lasers synchronisiert oder
b) das Substrat in Y-Richtung verschoben bzw. geschwenkt.

Aufstellung der verwendeten Bezugszeichen und Begriffe
- A -: Laserstrahl
- B -: Targetoberfläche
- C -: Normale des jeweils emittierenden Target-Oberflächenelementes
- D -: Laserstrahlfokus
- E -: Substratnormale
- F -: Schablonenführung
- G -: Substratlängsachse

## Patentansprüche

1. Verfahren zur Abscheidung dünner und dünnster Schichten mittels LPVD, bei dem die Targetoberfläche (B) gekrümmt ist und eine Relativbewegung von Strahlfokus (D) und Targetoberfläche (B) erfolgt, dadurch gekennzeichnet, daß eine Verkippung der Symmetrieachse der Plasmafackel (Strahlachse) und der Substratnormalen (E) gegeneinander durch entsprechende Target- und/oder Substratbewegung und die Targetbewegung durch X-Y-Verschiebung mittels Manipulator von außerhalb des Rezipienten und eine damit gekoppelte erzwungene Bewegung in Z-Richtung, die die infolge X-Bewegung hervorgerufene Abweichung der Targetoberfläche (B) aus dem Strahlfokus (D) kompensiert, erfolgen.

2. Verfahren nach Anspruch 1, dadurch gekennzeichnet, daß die erzwungene Bewegung in Z-Richtung durch Schablone erreicht wird.

## Claims

1. Method of separating fine and microfine layers by means of LPVD, in which the target surface (B) is curved, and a relative movement of beam focus (D) and target surface (B) is effected, characterised in that there are effected a tilting of the axis of symmetry of the plasma torch (beam axis) and of the substrate normal (E) relative to one another by corresponding target and/or substrate movement, the target movement being effected by means of a manipulator from outside the recipient and, coupled therewith, a constrained movement in the Z direction, which compensates for the deflection of the target surface (B) out of the beam focus (D) caused as a result of the X movement.

2. Method according to claim 1, characterised in that the constrained movement in the Z direction is obtained by a template.

## Revendications

1. Procédé pour déposer des couches minces et extrêmement minces au moyen d'un dépôt LPVD, selon lequel on cintre la surface cible (B) et on déplace l'un par rapport à l'autre le foyer d'irradiation (D) et la surface cible (B), caractérisé en ce qu'on fait basculer l'axe de symétrie du faisceau de plasma (axe du faisceau) et la normale (E) du substrat l'un par rapport à l'autre au moyen d'un déplacement correspondant de la cible et/ou du substrat et qu'on déplace la cible au moyen d'un déplacement X-Y à l'aide d'un manipulateur, à partir de l'extérieur du récipient, et qu'un déplacement imposé dans la direction Z, qui est accouplé au déplacement précédent et qui compense l'écart, qui est provoqué par le déplacement suivant X, entre la surface cible (B) et le foyer d'irradiation (D), est exécuté.

2. Procédé selon la revendication 1, caractérisé en ce que le déplacement imposé est exécuté dans la direction Z au moyen d'un gabarit.
